# FASCICULE DE BREVET EUROPEEN

(11) **EP 0 555 602 B1**
(45) Date de publication et mention de la délivrance du brevet: **03.09.1997**
(21) Numéro de dépôt: 92403051.3
(22) Date de dépôt: 12.11.1992
(51) Int. Cl.: G02F 1/00

(54) **Dispositif optique de mesure du courant dans une installation à enveloppe métallique à la terre**
Optische Strommesseinrichtung in einer Anlage mit geerdeter Metallkapselung
Optical current measuring device in an installation with grounded metallic enclosure

(30) Priorité: 18.11.1991 FR 9114174
(43) Date de publication de la demande: 18.08.1993
(73) Titulaire: GEC ALSTHOM SA, 75116 Paris (FR)
(72) Inventeur: Dupraz, Jean-Pierre, F-69003 Lyon (FR); Thuries, Edmond, F-69330 Meyzieu (FR)
(74) Mandataire: Fournier, Michel

(56) Documents cités:
- DE-A- 4 025 911
- FR-A- 2 209 937
- FR-A- 2 430 112
- FR-A- 2 613 838
- PATENT ABSTRACTS OF JAPAN vol. 14, no. 258 (P-1055)4 Juin 1990 & JP-A-20 69 671
- PATENT ABSTRACTS OF JAPAN vol. 11, no. 79 (P-555)11 Mars 1987 & JP-A-61 235 758

## Description

La présente invention concerne un dispositif optique pour le mesure du courant dans une installation à enveloppe métallique à la terre, désignée aussi sous les termes d'installation blindée.

On connaît bien, dans le domaine des installations électriques aériennes à haute tension, des dispositifs de mesure du courant utilisant l'effet Faraday, au moyen notamment de fibres optiques traversée par un rayonnement lumineux.

On rappelle que l'effet Faraday est un effet magnéto-optique résultant de l'interaction d'une onde électromagnétique et d'un milieu matériel en présence d'un champ magnétique.

Certains milieux matériels présentent, sous l'action d'un champ magnétique de même direction que l'onde électromagnétique, une activité optique se traduisant par une biréfringence circulaire induite, non réciproque, c'est-à-dire par des vitesses de propagation de l'onde dans le milieu, différentes selon qu'elle est à polarisation circulaire dextrogyre ou lévogyre.

La mise en oeuvre de l'effet Faraday pour la mesure de l'intensité d'un courant électrique se fait soit sur une onde lumineuse à polarisation linéaire, qui peut être considérée comme la somme de deux ondes à polarisation circulaire l'une dextrogyre et l'autre lévogyre, soit par deux ondes lumineuses contrapropagatives polarisées circulairement de la même manière lévogyre ou dextrogyre; dans le premier cas, on mesure la rotation du plan de polarisation par des techniques polarimétriques; dans le second cas, on mesure l'écart de phase par une technique interférométrique dite de Sagnac.

Dans les deux cas, l'angle de déphasage dû à l'effet Faraday est proportionnel à l'intensité instantanée du courant à mesurer.

Les ondes lumineuses utilisées pour la mise en oeuvre de la mesure sont véhiculées par une fibre optique qui entoure une ou plusieurs fois le conducteur électrique dont on mesure le courant.

La mesure par effet Faraday semble particulièrement avantageuse pour la mesure des courants dans une installation du type à enveloppe métallique à la terre ou installation de type blindé. En effet elle permet dans une telle installation une diminution importante de l'encombrement, puisque les transformateurs de courant utilisés classiquement entraînent un encombrement axial de plusieurs dizaines de centimètres. La mise en place d'une fibre optique entraîne un encombrement axial de quelques centimètres seulement. Par ailleurs, la mesure optique est insensible aux influences électromagnétiques existant dans une installation blindée. D'autres arguments militent en faveur de la mise en place dans les installations blindées de transformateur de courant de type optique:
- grande plage de fonctionnement, puisqu'on ne rencontre pas le phénomène de saturation du noyau magnétique qui limite la plage de fonctionnement des transformateurs de courant classiques,
- possibilité de standardisation du produit qui peut s'appliquer sans modification à tous les types d'installations ou de postes blindés,
- large gamme d'utilisation de l'appareil.

L'état de la technique dans ce domaine est illustré par l'article "Development of optical instrument transformers" par T. Sawa, K. Kurosawa, T. Kaminishi, T. Yokota référencé 89TD380-7PWRD, IEEE/PES 1989 Transmission and Distribution Conférence, 2 au 7 Avril 1989.

Une première difficulté rencontrée dans la mise en oeuvre dans une installation blindée d'un transformateur optique est d'assurer qu'il n'existe pas une trop grande différence de potentiel entre certains points de la fibre optique, ce qui pourrait conduire à des claquages.

Une autre difficulté est d'éviter un excès de température des boîtes optiques associées aux fibres qui assurent la détection du signal de mesure. En effet, il règne à l'intérieur des enveloppes des installations une température pouvant dépasser 90°C; il est nécessaire, pour garantir l'intégrité des appareils et la précision des mesures, que la température à l'intérieur des boîtes optiques associées n'excède pas 70°C environ.

Un but de l'invention est de résoudre ces problèmes techniques et de réaliser un transformateur optique dont les fibres optiques soient le siège d'une tension électrique relativement basse et dont les boîtes optiques associées soient à l'abri de tout excès de température.

Le document FR-A-2 430 112 décrit un transformateur de courant constitué de fibres optiques noyées dans un support isolant. Ce document n'enseigne pas de limiter les échanges thermiques entre les fibres et le boîtier de mesure.

Le document DE-A- 40 25 911 montre des fibres optiques et un boîtier à l'intérieur de l'enveloppe métallique d'une ligne blindée. Ces éléments sont donc sujets à des échauffements importants préjudiciables à leur bon fonctionnement.

L'invention a pour objet un transformateur de courant destiné à équiper une installation électrique du type à enveloppe métallique à la terre et comprenant au moins une enveloppe métallique cylindrique remplie de gaz diélectrique et contenant au moins un conducteur disposé parrallèlement à l'axe de l'enveloppe, le transformateur étant du type à effet Faraday et comprenant, pour chaque conducteur, un fibre optique l'entourant, ladite fibre étant reliée à une boîte optique auxiliaire assurant l'injection dans la fibre d'au moins une onde lumineuse d'entrée et le traitement des ondes lumineuses de sortie, ledit transformateur de courant étant caractérisé en ce qu'il comprend un support en forme de disque dont le plan est perpendiculaire audit axe et dont la périphérie vient en contact avec une section droite intérieure de l'enveloppe, ledit disque comprenant au moins une ouverture à travers laquelle passe l'un desdits conducteurs, ladite ouverture comportant une gorge à l'intérieur de laquelle est placée ladite fibre optique qui fait au moins un tour autour dudit conducteur et dont les deux extrémités sont reliées à ladite boîte optique associée disposée à l'extérieur de l'enveloppe, ladite boîte optique étant placée dans une enceinte communiquant avec ladite enveloppe par un passage étanche dans lequel passent lesdites fibres optiques.

Avantageusement, ladite enceinte est munie de moyens de refroidissement.

De préférence, ledit passage est muni de moyens pour limiter l'échange de chaleur par conduction et convexion entre ladite enceinte et ladite enveloppe.

Dans un mode particulier de réalisation, les moyens précités comprennent des chicanes et/ou diaphragmes en matériau poreux à faible conductibilité thermique.

En variante, ledit passage est rempli d'un matériau à base de silicone.

Lesdits moyens de refroidissement sont avantageusement constitués par des ailettes métalliques à l'extérieur de ladite enceinte, celle-ci étant réalisée en métal.

En variante, lesdits moyens de refroidissement comprennent une circulation de fluide réfrigérant tel que le fréon.

Dans un mode particulier de réalisation de l'invention, le disque est métallique et les fibres optiques sont directement placées dans ladite gorge.

En variante, le disque est réalisé en matériau isolant tel que la résine époxy.

Dans ce dernier cas, les fibres optiques peuvent être disposées dans un tube isolant.

Dans le cas où l'enveloppe contient trois conducteurs triphasés, une fibre optique peut être placée à la périphérie du disque et faire au moins un tour autour des trois conducteurs, cette fibre étant utilisée pour la mesure du courant homopolaire.

L'invention sera bien comprise à la lecture de la description donnée ci-après de divers modes de réalisation de l'invention, en référence au dessin annexé dans lequel:
- la figure 1 est une vue en coupe axiale d'une enveloppe blindée monophasée comprenant un transformateur optique selon l'invention,
- la figure 2 est une vue en coupe selon la ligne II-II de la figure 1,
- la figure 3 est une vue partielle du transformateur optique selon une variante de réalisation,
- la figure 4 est une vue partielle en coupe axiale d'une enveloppe blindée triphasée comprenant un transformateur optique selon l'invention.

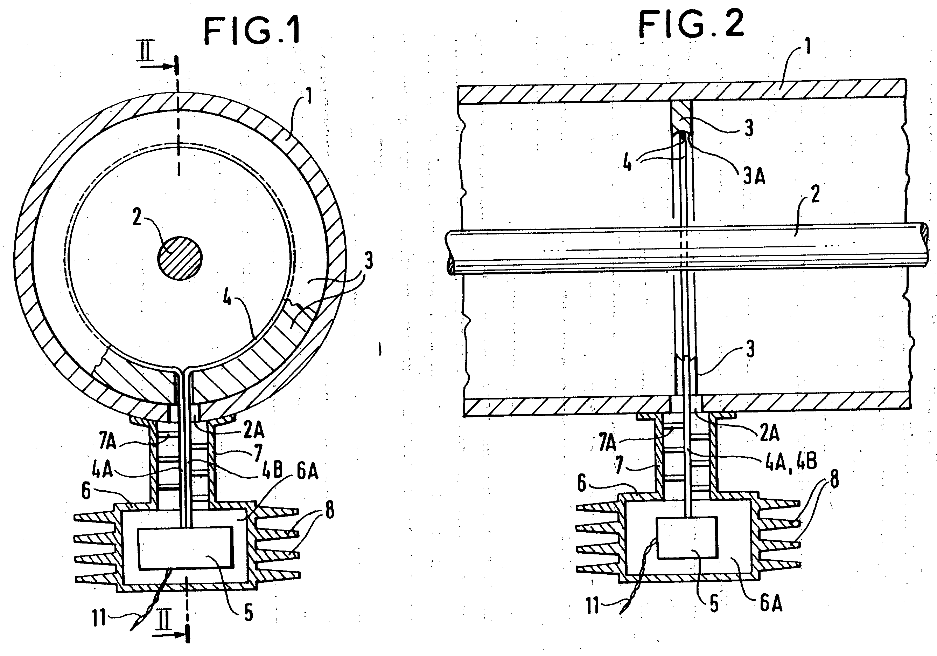

Dans la figure 1, la référence 1 désigne une enveloppe métallique à la terre d'une installation monophasée; l'enveloppe 1 est remplie de gaz à bonnes propriétés diélectriques tel que l'hexafluorure de soufre SF6, sous une pression de quelques bars. L'enveloppe contient un conducteur métallique 2, maintenu au moyen de cônes isolants non représentés.

Le transformateur optique de l'invention comprend un disque 3, disposé perpendiculairement au conducteur 2, et dont la périphérie vient épouser la surface intérieure de l'enveloppe métallique 2. Ce disque est fixé à l'enveloppe par tout moyen conventionnel bien connu tel que bride vissée, pincement entre deux brides, etc.
Le disque 2 comprend une ouverture circulaire permettant le passage du conducteur 2. La périphérie de cette ouverture comporte une gorge 3A dans laquelle est disposée une fibre optique 4, faisant un ou plusieurs tours de la gorge. La fibre optique est fixée au fond de la gorge par exemple par collage.

Les extrémités 4A et 4B de la fibre sont reliée à une boîte optique associée 5, qui comprend notamment des moyens pour élaborer au moins une onde lumineuse, des moyens pour injecter cette onde dans au moins une des extrémités de la fibre optique, et des moyens pour recueillir et traiter l'onde lumineuse sortant des extrémités de la fibre. La boîte 5 peut être reliée à un centre d'alimentation et de traitement par une liaison électrique et/ou optique 11. Une telle boîte optique associée est bien connue et on pourra par exemple se référer au brevet français n° 87 05102 qui en donne un exemple de réalisation non limitatif.

Le disque 3 peut être métallique; dans ce cas les points de la fibre optique à l'intérieur de la gorge sont au potentiel de la masse et aucun risque de claquage dû à la fibre n'est à craindre; le disque 3 peut, en variante, être en matériau isolant; comme l'ouverture du disque est grande, la gorge 3A est éloignée du conducteur 2; la valeur du potentiel au niveau de la gorge 3A est faible et, là encore aucun risque de claquage dû à la présence de la fibre optique n'est à redouter. On voit donc qu'un premier problème technique est résolu.

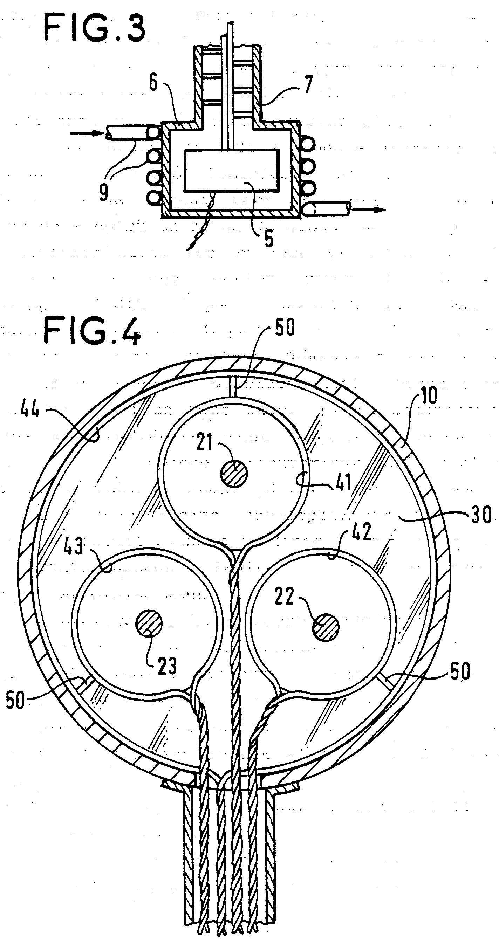

Le second problème technique est résolu comme suit: la boîte optique associée est placée dans une enceinte 6, extérieure à l'enveloppe 2, et dont l'intérieur 6A communique avec l'intérieur de l'enveloppe par un passage 7 fixé de manière étanche à l'enveloppe 2 au droit d'une trou 2A de cette dernière. Les brins de fibre optique 4A et 4B empruntent ce passage. Pour limiter l'échauffement à l'intérieur de l'enceinte 6, le passage 7 est muni de chicanes ou diaphragmes 7A en matériau mauvais conducteur de la chaleur, assurant une limitation de la transmission par convexion ou conduction de la chaleur en provenance de l'enveloppe 2. Si cette mesure est insuffisante, l'enceinte 6, réalisée en métal, est munie d'ailettes de refroidissement 8 coopérant avec l'air ambiant, ou d'un circuit de réfrigération 9, alimenté par exemple par du fréon (Fig. 3).

La figure 4 illustre une installation triphasée munie d'un transformateur selon l'invention. Elle comporte une enveloppe métallique étanche à la masse 10 remplie de SF6 à l'intérieur de laquelle sont placés trois conducteurs 21, 22 et 23. Le transformateur optique comprend un disque 30 muni de trois ouvertures pour le passage des conducteurs. Des fentes telles que 50 dans le disque évitent d'en faire une spire en court-circuit. Chaque ouverture possède une gorge intérieure dans laquelle est placée une fibre optique (respectivement 41, 42 et 43) faisant au moins un tour et dont les brins sont reliés, comme dans les figures précédentes, à une boîte optique associée extérieure à l'enveloppe et non représentée dans la figure 4. Les brins de sortie des fibres ont été représentés enroulés en hélices, comme il est assez habituel de le faire.

Comme précédemment, le disque 30 peut être métallique et les fibres sont au potentiel de la terre; en variante, le disque est en matériau isolant tel que la résine époxy, et les ouvertures du disque sont grandes pour que les fibres soient éloignées le plus possible des conducteurs respectifs et donc au potentiel le plus faible possible.

Comme il est habituel, les fibres optiques peuvent être protégées par des tubes en plastique. Le disque 30 peut être muni d'une gorge périphérique dans laquelle est placée une fibre optique 44 faisant au moins un tour autour de la gorge, donc autour des trois conducteurs 21, 22 et 23; cette fibre, reliée à la boîte optique associée, permet la mesure du courant homopolaire, souvent utile dans les dispositifs de protection des installations électriques.

L'invention s'applique à l'équipement de toute installation électrique à enveloppe métallique à la terre, monophasée ou polyphasée.

## Revendications

1. Transformateur de courant destiné à équiper une installation électrique du type à enveloppe métallique à la terre et comprenant au moins une enveloppe métallique cylindrique (1) remplie de gaz diélectrique et contenant au moins un conducteur (2; 21, 22, 23) disposé parallèlement à l'axe de l'enveloppe, le transformateur étant du type à effet Faraday et comprenant, pour chaque conducteur, un fibre optique l'entourant, ladite fibre étant reliée à une boîte optique auxiliaire (5) assurant l'injection dans la fibre d'au moins une onde lumineuse d'entrée et le traitement des ondes lumineuses de sortie, ledit transformateur de courant étant caractérisé en ce qu'il comprend un support (3, 30) en forme de disque dont le plan est perpendiculaire audit axe et dont la périphérie vient en contact avec une section droite intérieure de l'enveloppe (1), ledit disque comprenant au moins une ouverture à travers laquelle passe l'un desdits conducteurs (2; 21, 22, 23), ladite ouverture comportant une gorge à l'intérieur de laquelle est placée ladite fibre optique (4; 41, 42, 43) qui fait au moins un tour autour dudit conducteur (2; 21, 22, 23) et dont les deux extrémités sont reliées à ladite boîte optique associée (5) disposée à l'extérieur de l'enveloppe, ladite boîte optique étant placée dans une enceinte (6) communiquant avec ladite enveloppe par un passage étanche (7) dans lequel passent lesdites fibres optiques.

2. Transformateur selon la revendication 1, caractérisé en ce que ledit passage (7) est muni de moyens pour limiter l'échange de chaleur par conduction et convexion entre ladite enceinte (6) et ladite enveloppe (1).

3. Transformateur selon la revendication 2, caractérisé en ce que lesdits moyens comprennent des chicanes et/ou diaphragmes (7A) en matériau poreux à faible conductibilité thermique.

4. Transformateur selon l'une des revendications 1 à 3, caractérisé en ce que ladite enceinte (6) comprend des moyens de refroidissement (8, 9).

5. Transformateur selon la revendication 4, caractérisé en ce que lesdits moyens de refroidissement sont avantageusement constitués par des ailettes métalliques (8) à l'extérieur de ladite enceinte, celle-ci étant réalisée en métal.

6. Transformateur selon la revendication 4, caractérisé en ce que lesdits moyens de refroidissement comprennent une circulation (9) de fluide réfrigérant tel que le fréon.

7. Transformateur selon l'une des revendications 1 à 6, caractérisé en ce que le disque (1, 10) est métallique et les fibres optiques sont directement placées dans ladite gorge.

8. Transformateur selon l'une des revendications 1 à 6, caractérisé en ce que le disque (1, 10) est réalisé en matériau isolant tel que la résine époxy.

9. Transformateur selon la revendication 8, caractérisé en ce que les fibres optiques (4; 41, 42, 43) sont disposées dans un tube isolant disposé dans la gorge du disque.

10. Transformateur triphasé selon la revendication 1, caractérisé en ce que le disque (30) est muni de trois ouvertures circulaires centrées sur les conducteurs, chaque ouverture étant munie à sa périphérie d'une gorge circulaire recevant une fibre optique (41, 42, 43), le diamètre des ouvertures étant choisi suffisamment grand pour éviter tout risque de claquage, le disque comportant au moins une fente pour éviter qu'il constitue une spire en court-circuit.

11. Transformateur selon la revendications 10, caractérisé en ce qu'une fibre optique supplémentaire (44) est placée à la périphérie du disque (30) et fait au moins un tour autour des trois conducteurs, cette fibre étant utilisée pour la mesure du courant homopolaire.

## Patentansprüche

1. Stromtransformator für eine elektrische Anlage mit mindestens einer geerdeten Metallhülle (1), die mit einem dielektrischen Gas gefüllt ist und mindestens einen parallel zur Achse der Hülle verlaufenden Leiter (2; 21, 22, 23) enthält, wobei der Transformator auf dem Faraday-Effekt beruht und für jeden Leiter eine den Leiter umschlingende Lichtleitfaser enthält, die an ein optisches Hilfsgerät angeschlossen ist, welches die Einspeisung mindestens einer Eingangslichtwelle in die Faser und die Verarbeitung der Ausgangslichtwellen bewirkt, dadurch gekennzeichnet, daß der Transformator einen Träger (3, 30) in Form einer Scheibe besitzt, dessen Ebene senkrecht zu der Achse liegt und dessen Rand mit einem inneren Querschnitt der Hülle (1) in Berührung kommt, daß die Scheibe mindestens eine Öffnung aufweist, durch die einer der Leiter (2; 21, 22, 23) verläuft und die eine Rinne aufweist, in der die Lichtleitfaser (4; 41, 42, 43) verlegt ist, die mindestens einmal um den Leiter (2; 21, 22, 23) herum verläuft und deren beide Enden an das zugeordnete optische Gerät angeschlossen sind, wobei dieses Gerät außerhalb der Hülle in einem Behälter (6) untergebracht ist, der mit der Hülle über einen dichten Durchlaß (7) in Verbindung steht, durch den die Lichtleitfasern verlaufen.

2. Transformator nach Anspruch 1, dadurch gekennzeichnet, daß der Durchlaß (7) Mittel zur Begrenzung des Wärmeaustauschs mittels Wärmeleitung und Konvektion zwischen dem Behälter (6) und der Hülle (1) aufweist.

3. Transformator nach Anspruch 2, dadurch gekennzeichnet, daß diese Mittel Schikanen und/oder Blenden (7A) aus einem porösen Material mit geringer Wärmeleitfähigkeit enthalten.

4. Transformator nach einem der Ansprüche 1 bis 3, dadurch gekennzeichnet, daß der Behälter (6) Kühlmittel (8, 9) aufweist.

5. Transformator nach Anspruch 4, dadurch gekennzeichnet, daß die Kühlmittel vorzugsweise aus Metallrippen (8) an der Außenseite des Behälters bestehen, der ebenfalls aus Metall ist.

6. Transformator nach Anspruch 4, dadurch gekennzeichnet, daß die Kühlmittel einen Kühlkreislauf (9) für ein Kühlmittel wie z.B. Freon besitzen.

7. Transformator nach einem der Ansprüche 1 bis 6, dadurch gekennzeichnet, daß die Scheibe (1, 10) aus Metall ist und daß die Lichtleitfasern direkt in der Rinne verlegt sind.

8. Transformator nach einem der Ansprüche 1 bis 6, dadurch gekennzeichnet, daß die Scheibe (1, 10) aus einem isolierenden Material wie z.B. Epoxyharz ist.

9. Transformator nach Anspruch 8, dadurch gekennzeichnet, daß die Lichtleitfasern (4; 41, 42, 43) in einem Isolierröhrchen verlegt sind, das in der Rinne der Scheibe angeordnet ist.

10. Dreiphasen-Transformator nach Anspruch 1, dadurch gekennzeichnet, daß die Scheibe (30) drei kreisförmige und auf die Leiter zentrierte Öffnungen besitzt, daß jede Öffnung an ihrer Peripherie eine kreisförmige Rinne zur Verlegung einer Lichtleitfaser (41, 42, 43) besitzt, daß der Durchmesser der Öffnungen ausreichend groß gewählt ist, um die Gefahr eines Überschlags auszuschließen, und daß die Scheibe mindestens einen Schlitz aufweist, um zu vermeiden, daß sich eine Kurzschlußschleife bildet.

11. Transformator nach Anspruch 10, dadurch gekennzeichnet, daß eine zusätzliche Lichtleitfaser (44) an der Peripherie der Scheibe (30) verlegt ist und mindestens einmal um alle drei Leiter herum verläuft, wobei diese Faser zur Messung des homopolaren Stroms verwendet wird.

## Claims

1. A current transformer designed to equip an electrical installation of the grounded metal-clad type including at least one cylindrical metal cladding (1) filled with dielectric gas and containing at least one conductor (2; 21, 22, & 23) that is disposed parallel to the axis of the cladding, the transformer being of the Faraday-effect type and including, for each conductor, an optical fiber surrounding the conductor, said fiber being connected to an auxiliary optical interface (5) for injecting at least one input light wave into the fiber, and for processing the output light waves, said current transformer being characterized in that it includes a support (3, 30) in the form of a disk having its plane perpendicular to said axis and having its periphery in contact with a cross-section inside the cladding (1), said disk having at least one opening via which one of said conductors (1; 21, 22, & 23) passes, said opening including a groove inside which said optical fiber (4; 41, 42, & 43) is placed, the optical fiber going at least once round said conductor (2; 21, 22, & 23), and having its two ends connected to said associated optical interface (5) disposed outside the cladding, said optical interface being placed in an enclosure (6) that communicates with said cladding via a gastight passage (7) through which said optical fibers pass.

2. A transformer according to claim 1, characterized in that said passage (7) is equipped with means for limiting the heat exchange that takes place by conduction and by convection between said enclosure (1) and said cladding (6).

3. A transformer according to claim 2, characterized in that said means comprise baffles and/or diaphragms (7A) made of a porous material having poor thermal conductivity.

4. A transformer according to any one of claims 1 to 3, characterized in that said enclosure (6) includes cooling means (8, 9).

5. A transformer according to claim 4, characterized in that said cooling means are advantageously constituted by metal fins (8) outside said enclosure, the enclosure being made of metal.

6. A transformer according to claim 4, characterized in that said cooling means comprise a circuit (9) through which a coolant such as Freon circulates.

7. A transformer according to any one of claims to 6, characterized in that the disk (1, 10) is made of metal and the optical fibers are placed directly in said groove.

8. A transformer according to any one of claims to 6, characterized in that the disk (1, 10) is made of an insulating material such as epoxy resin.

9. A transformer according to claim 8, characterized in that the optical fibers (4; 41, 42, & 43) are disposed inside an insulating tube disposed in the groove in the disk.

10. A three-phase transformer according to claim 1, characterized in that the disk (30) is equipped with three circular openings centered on the conductors, the periphery of each opening being provided with a circular groove for receiving an optical fiber (41, 42, 43), the diameter of the openings being chosen to be large enough to avoid any danger of breakdown, the disk including at least one slot to prevent it from constituting a short-circuit winding.

11. A transformer according to claim 10, characterized in that an additional optical fiber (44) is placed at the periphery of the disk (30) and goes at least once round the three conductors, the additional fiber being used to measure the residual current.
